# EUROPEAN PATENT APPLICATION

(11) **EP 4 040 923 A1**
(43) Date of publication of application: **10.08.2022**
(21) Application number: 19952573.4
(22) Date of filing: 14.11.2019
(51) Int. Cl.: H05K 1/18, H04N 5/232

(54) **CIRCUIT BOARD, CAMERA MODULE, AND MOBILE TERMINAL**

(71) Applicant: Nanchang O-Film Optical-Electronic Tech Co., Ltd, 330013 Jiangxi (CN)
(72) Inventor: QU, Jiajia, Jiangxi 330013 (CN); LI, Yong, Jiangxi 330013 (CN); AHN, Jae Wook, Jiangxi 330013 (CN)
(74) Representative: Fassio, Valeria
(86) International application number: PCT/CN2019/118535
(87) International publication number: WO 2021/092854

(57) **Abstract**

A circuit board and a camera module. A first board body of the circuit board can slide under the action of a drive force so as to drive a photosensitive chip to displace relative to a lens component to achieve optical anti-shake. An output pin of a second board body of the circuit board can be electrically connected to a motherboard of a mobile terminal, and the second board body is fixed on a base. When the first board body moves, the position of the second board body can be maintained fixed, therefore, there is no pulling between the second board body and the motherboard. Therefore, joints are effectively prevented from loosening due to the pulling force. Furthermore, a connecting member can be deformed with the movement of the first board body; therefore, the movement of the first board body is not limited. Therefore, the first board body of the circuit board receives a small resistance during the sliding process. Hence, the camera module has a high reliability while achieving optical anti-shake.

## Description

### TECHNICAL FIELD

The present application relates to the field of optical imaging technology, in particular, to a circuit board, a camera module, and a mobile terminal.

### BACKGROUND

Optical image stabilization is a widely recognized anti-shake technology, which compensates for vibrating light paths with movable components, so as to reduce the blurring in photos. The optical image stabilization technology is mainly divided into two categories, namely, lens movable optical image stabilization, and photosensitive chip movable optical image stabilization.

The lens movable optical image stabilization has a complex structure and is generally not suitable for application in a camera module of a mobile terminal. Therefore, the photosensitive chip movable optical image stabilization has received more and more attention. The core principle of the photosensitive chip movable optical image stabilization lies in that under the action of driving force, the photosensitive chip can be displaced, thereby compensating for an offset of an optical axis of the lens caused by shaking.

The photosensitive chip needs to be connected to a mainboard of the mobile terminal. When the photosensitive chip moves, it will be pulled by the mainboard due to the relative movement. Under the action of pulling force, various connections are prone to loosening. In addition, there is more resistance during movement. Therefore, the reliability of the existing camera module is not high when the photosensitive chip movable optical image stabilization is realized.

### SUMMARY

According to various embodiments of the present application, a circuit board, a camera module, and a mobile terminal are provided.

A circuit board is applied in a camera module and includes:
a first board body provided with a photosensitive chip on a surface thereof;
a second board body provided with output pins; and
a connecting member connected between the second board body and the first board body. As the first board body approaches or moves away from the second board body relatively, at least a part of the connecting member is deformed.

A camera module includes:
a base;
a lens carrier equipped with a lens assembly, mounted on the base; and
the circuit board according to any one of the preferred embodiments. A side of the first board body facing away from the photosensitive chip is slidably mounted on the base. The second board body is fixed on the base. The first board body is disposed between the lens assembly and the base, and the first board body is disposed perpendicular to an optical axis of the lens assembly.

A mobile terminal includes the camera module according to any one of the embodiments.

Details of one or more embodiments of the present application are set forth in the accompanying drawings and the description below. Other features, objects and advantages of the present application will become apparent from the description, drawings and claims.

### BRIEF DESCRIPTION OF THE DRAWINGS

FIG. 1 is a schematic view of a camera module according to a preferred embodiment of the present application.
FIG. 2 is an exploded view of the camera module shown in FIG. 1.
FIG. 3 is a cross-sectional view of the camera module shown in FIG. 1.
FIG. 4 is a schematic view of a circuit board of the camera module shown in FIG. 1.

### DETAILED DESCRIPTION OF THE EMBODIMENTS

In order to facilitate understanding of the present application, the present application will be described more fully hereinafter with reference to the related drawings. Preferred embodiments of the present application are shown in the accompanying drawings. However, the present application may be embodied in many different forms and is not limited to the embodiments described herein. Rather, providing these embodiments is to provide a thorough and complete understanding of the present application.

It should be noted that when an element is referred to as being "fixed to" another element, it can be directly on the other element or an intermediate element may also be present. When an element is referred to as being "connected to" another element, it can be directly connected to another element or an intermediate element may also be present at the same time. The terms "vertical", "horizontal", "left", "right", and similar expressions used herein are for illustrative purposes only.

Unless otherwise defined, all technical and scientific terms used herein have the same meaning as commonly understood by one of ordinary skill in the art to which the present application belongs. The terms used herein in the description of the present application are for the purpose of describing specific embodiments only, and are not intended to limit the present application. As used herein, the term "and/or" includes any and all combinations of one or more of the associated listed items.

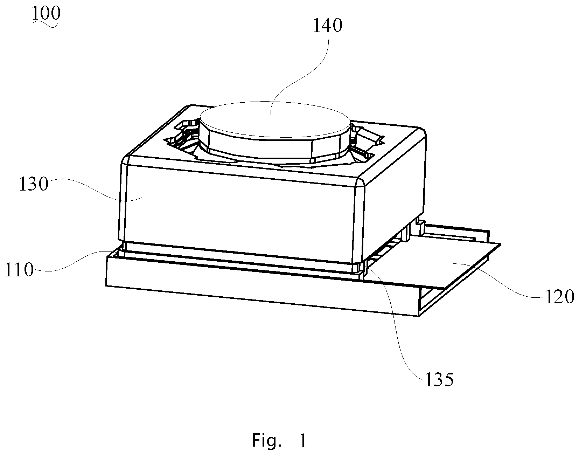

Referring to FIG. 1, the present application provides a circuit board 120 and a camera module 100. The present application further provides a mobile terminal including the camera module 100 accordingly. With the camera module 100, the mobile terminal can realize the shooting function. The mobile terminal may be an electronic product such as a mobile phone, a PAD, and a camera.

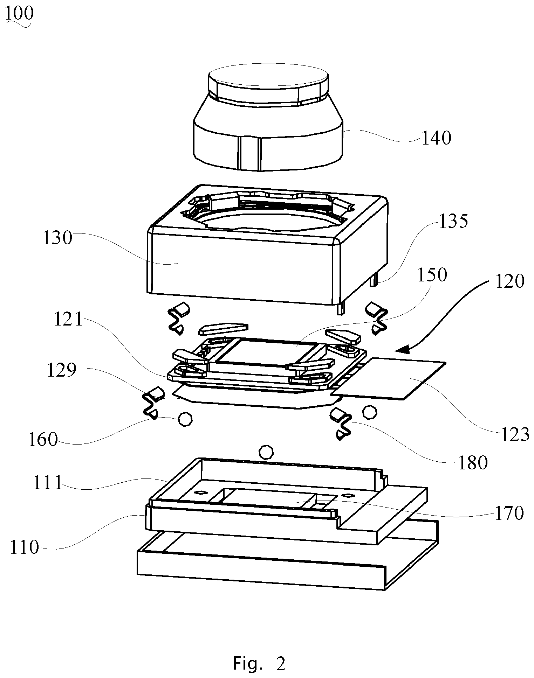

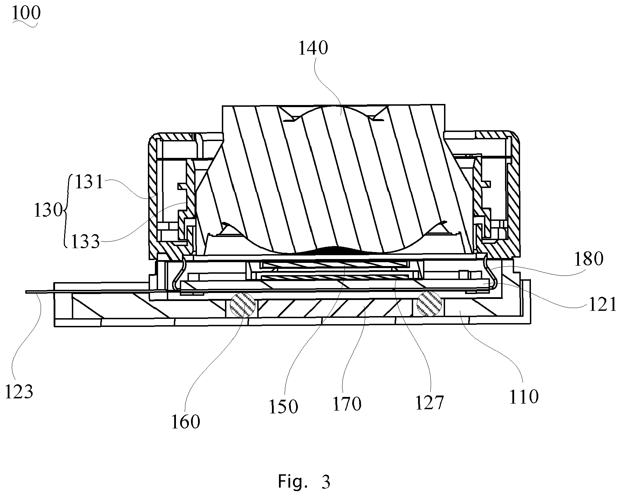

Referring to FIGS. 2 and 3, the camera module 100 according to a preferred embodiment of the present application includes a base 110, a circuit board 120, a lens carrier 130, and a lens assembly 140.

The base 110 functions as carrying, and is generally integrally formed by a metal material. According to different shaping requirements of the camera module 100, an outer contour of the base 110 can be of various shapes such as a circle and a rectangle correspondingly. The lens carrier 130 is mounted on the base 110 such that a space for receiving the circuit board 120 is formed between the lens assembly 140 and the base 110. The lens assembly 140 is generally formed by stacking a plurality of lenses having different focal lengths, and optical axes of the plurality of lenses generally coincides with a central axis of the lens assembly 140. For a circular lens, the optical axis passes through a center of the circular lens.

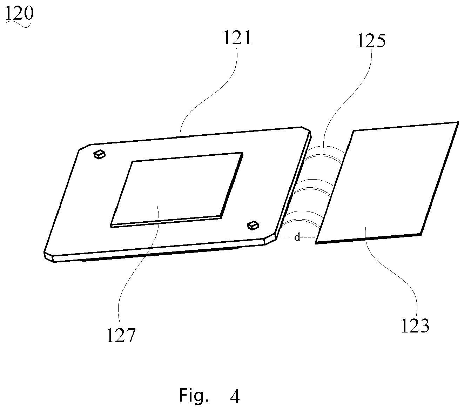

Referring to FIG. 4, the circuit board 120 is generally a printed circuit board (PCB) on which many electronic elements are integrated. The circuit board 120 includes a first board body 121, a second board body 123, and a connecting member 125.

The first board body 121 and the second board body 123 can be regarded as two parts formed by cutting a common circuit board, and electronic elements are respectively integrated on the two parts. However, the connecting member 125 allows the first board body 121 and the second board body 123 to function as a whole. Specifically, the first board body 121 is provided with a photosensitive chip 127. The photosensitive chip 127 is used to convert light into electrical signals to realize imaging. The second board body 123 is provided with output pins (not shown in the figure), which are used to be electrically connected to a mainboard of the mobile terminal.

In order to improve the imaging effect of the photosensitive chip 127, in this embodiment, the camera module 100 further includes an optical filter 150 capable of filtering out invisible light. The optical filter 150 is covered on a surface of the photosensitive chip 127. Specifically, the optical filter 150 may be a blue glass, which is used to filter out the invisible light, so as to avoid interference, thereby preventing noise from being generated on the image.

In addition, in order to sense the shaking of the camera module 100 and realize anti-shake, a gyroscope (not shown in the figure), a driving chip (not shown in the figure), a driving mechanism (not shown in the figure) and the like may be further integrated on the circuit board 120. The gyroscope detects the shaking and quantifies the degree of shaking. The driving chip generates a driving current according to the magnitude of shaking. The driving mechanism compensates for shaking under the action of the driving current.

The connecting member 125 is connected between the second board body 123 and the first board body 121. As the first board body 121 approaches or moves away from the second board body 123 relatively, at least a part of the connecting member 125 is deformed. That is, the second board body 123 and the first board body 121 can move independently of each other without interfering with each other.

Further, a side of the first board body 121 facing away from the photosensitive chip 127 is slidably mounted on the base 110. The second board body 123 is fixed on the base 110. Moreover, the first board body 121 is disposed between the lens assembly 140 and the base 110, and the first board body 121 is disposed perpendicular to an optical axis of the lens assembly 140. The light can enter the photosensitive chip 127 through the lens assembly 140 to realize imaging. Specifically, the first board body 121 can slide in a direction perpendicular to the optical axis of the lens assembly 140. When the driving mechanism compensates for shaking, the first board body 121 is driven to slide in the direction perpendicular to the optical axis of the lens assembly 140, thereby driving the photosensitive chip 127 on the first board body 123 to move, so as to compensate for an offset of the optical axis of the lens assembly 140, and realize the photosensitive chip movable optical image stabilization.

Since the photosensitive chip 127 moves with the first board body 121, there is no relative movement between the photosensitive chip 127 and the first board body 121. There is no pulling between the photosensitive chip 127 and the circuit board 120, which effectively avoids loosening of the connection. Furthermore, the second board body 123 is fixed to the base 110. When the first board body 121 moves, a position of the second board body 123 can be kept fixed, and thus there will be no pulling between the second board body 123 and the mainboard, and loosening of the connection between the output pins and the mainboard will not occur. Moreover, the second board body 123 does not limit the movement of the first board body 121. Therefore, the resistance encountered by the first board body 121 during the sliding process is also smaller.

The connecting member 125 can have various forms, as long as the second board body 123 and the first board body 121 can be linked together as a whole, and the second board body 123 and the first board body 121 can be moved independently. For example:

Specifically, in this embodiment, the connecting member 125 is a flexible connecting member. As the first board body 121 approaches or moves away from the second board body 123 relatively, the bending degree of the flexible connecting member changes.

The flexible connecting member can be of a structure having better flexibility and electrical conductivity such as a flat cable, a silver wire, and can be deformed under the extrusion and pulling. Specifically, a length of the flexible connecting member is greater than a distance d between the first board body 121 and the second board body 123 in an initial state. As a result, the flexible connecting member is bent. As the first board body 121 moves, the flexible connecting member can be gradually unfolded, and the bending degree is reduced, so that the first board body 121 will not be pulled. Therefore, when the relative movement between the first board body 121 and the second board body 123 occurs, the encountered resistance is small.

Further, in this embodiment, the flexible connecting member is a plurality of flexible cables arranged side by side and at intervals, one end of each flexible cable is electrically connected to the first board body 121, and the other end of each flexible cable is electrically connected to the second board body 123.

Specifically, the plurality of flexible cables separated from each other realize the electrical connection between the first board body 121 and the second board body 123, so that a wire diameter of a single flexible cable can be set smaller, and thus the single flexible cable has better flexibility. As the first board body 121 approaches or moves away from the second board body 123, the flexible cable can be folded or unfolded with less resistance. Moreover, when the first board body 121 and the second board body 123 are laterally displaced from each other (i.e., the first board body 121 and the second board body 123 are relatively moved in a direction perpendicular to an extending direction of the flexible cable), due to the flexibility of the cable, the obstruction to the first board body 121 is also small. Therefore, the resistance encountered by the first board body 121 when moving in all directions can be reduced.

It should be noted that, in other embodiments, the flexible connecting member may also be other flexible members. For example, the flexible connecting member may also be a flexible plate.

In another embodiment, the connecting member 125 is an elastic retractable member that is extensible. As the first board body 121 approaches or moves away from the second board body 123 relatively, the elastic retractable member 125 is elastically deformed to change its length.

Specifically, the elastic retractable member may be a metal spring, or may be of a helical structure formed by winding an ordinary conducting wire. The elastic retractable member will generate elastic restoring force after its own length changes. In this way, when the force to respond to the anti-shake disappears, the first board body 121 will be automatically reset under the action of the elastic retractable member. Moreover, due to the helical structure, the conducting wires can be regularly placed between the first board body 121 and the second board body 123, thereby avoiding the winding of the wires inside the camera module 100.

In order to further reduce the resistance encountered by the first board body 121 during the sliding process, in this embodiment, the camera module 100 further includes a plurality of balls 160 disposed on the base 110. A side of the first board body 121 facing away from the photosensitive chip 127 rests on a side of the plurality of balls 111 facing away from the base 110.

The balls 160 are spherical and can roll relative to the base 110. Moreover, the ball 160 needs to have high hardness so as not to be deformed easily. Specifically, the balls 160 may be formed of materials with relatively high hardness, such as metal, ceramics, glass, sapphire, and the like.

The plurality of balls 160 generally have the same diameter, and can be directly distributed on the base 110. Specifically, a plane can be provided on the base 110, and the balls 160 are directly placed in the plane and can roll in the plane. An edge of the plane is bordered to prevent the balls 160 from rolling out of the plane. Further, the balls 160 are limited to the base 110 by the pressing of the first board body 121. In addition, receiving structures such as grooves, holes, and sleeves may be formed on the base 110 for receiving the balls 160, to prevent the balls from being scattered, thereby facilitating assembly and improving the reliability of the camera module 100.

The side of the first board body 121 facing away from the photosensitive chip 127 rests on the side of the plurality of balls 160 facing away from the base 110, that is, the plurality of balls 160 are supported between the first board body 121 and the base 110, and the plurality of balls 160 are in point contact with the first board body 121 and the base 110 respectively. In this case, the plurality of balls 160 may jointly define a sliding plane (not shown in the figure) that is tangent to the plurality of balls 160, and the first board body 121 may slide along the sliding plane. Since three points define a plane, at least three balls 160 are provided.

Since the first board body 121 is in point contact with the balls 160, when the first board body 121 slides, the balls 160 will also roll relative to the base 110 under the friction. Therefore, the friction encountered by the first board body 121 during the sliding process is relatively small rolling friction. Therefore, only a small driving force is required to drive the circuit board 120 to slide, as such, the anti-shake response is fast, has higher sensitivity, and lower energy consumption.

Moreover, the balls 160 roll as the first board body 121 slides. However, a surface of the ball 160 is spherical. The rolling of the ball 160 does not cause the height fluctuation of the sliding plane defined by the ball 160. Therefore, the first board body 121 will always remain in the same plane when sliding, that is, the flatness is better.

It should be pointed out that, in other embodiments, the first board body 121 can also be slidably mounted on the base 110 by means of a suspension wire hanging, an electric drive bracket, or the like.

Further, the camera module 100 according to this embodiment further includes a limiting member 170. The limiting member 170 is used to provide an acting force directed to the ball 160 to the first board body 121. The acting force on the first board body 121 can keep the first board body 121 in contact with the balls 160 all the time. Otherwise, a stable support cannot be formed between the first board body 121 and the balls 160, and the first board body 121 will be separated from the balls 160 when shaken or turned over.

The acting force provided by the limiting member 170 may be a pressure force or a tensile force. The limiting member 170 may exert the force on the first board body 121 in a direct contact manner, or in a non-contact manner. The limiting member 170 can have various forms, as long as it does not interfere with the sliding of the first board body 121.

Further, in this embodiment, the limiting member 170 is a magnet disposed on the base 110, and a ferromagnetic member 129 that can be attracted by the magnet is provided on the first board body 121.

The ferromagnetic member 129 may be a member formed of iron, nickel, or cobalt. The magnet is attracted to the ferromagnetic member 129, so that a pulling force directed to the ball 160 is exerted on the first board body 121. Moreover, through the attraction of the magnet, the limiting member 170 exerts the force on the first board body 121 in a non-contact manner. Therefore, the first board body 121 does not encounter the friction from the limiting member 170, and thus the sliding resistance encountered by the first board body 121 is smaller.

In addition, the magnets always remain fixed in the magnetic field. Therefore, when the ferromagnetic member 129 deviates from the initial position due to sliding with the first board body 121, the attraction force of the magnet to the ferromagnetic member 129 will cause the ferromagnetic member 129 to have a tendency to reset. That is, after the shaking is eliminated and the driving force acting on the first board body 121 disappears, the first board body 121 can also be automatically reset under the driving of the ferromagnetic member 129.

It should be noted that, in other embodiments, the limiting member 170 may also have other forms. For example:

The limiting member 170 may be a stretched elastic cord, one end of which is fixed to the base 110 and the other end of which is fixed to the first board body 121. Through the pulling force of the elastic cord, an acting force directed to the ball 160 can also be exerted on the first board body 121. Moreover, after the shaking is eliminated and the driving force acting on the first board body 121 disappears, the elastic cord can also pull the first board body 121 to automatically reset. For another example:

The limiting member 170 may also be a structure composed of a sleeve, a spring, and a rolling ball (which may have the same structure as the ball 160). The spring and the rolling ball are accommodated in the sleeve, and the compression of the spring produces an acting force on the rolling ball. The sleeve is directed to a surface of the first board body 121 facing away from the balls 160 (i.e., an upper surface shown in the figure), and the rolling ball abuts against the upper surface. Under the elastic force of the spring, the rolling ball exerts an acting force directed to the ball 160 on the first board body 121. In this case, the upper and lower surfaces of the first board body 121 are both supported by rolling, and thus the sliding thereof is not affected.

In this embodiment, the lens carrier 130 is a voice coil motor. The lens carrier 130 includes a housing 131 and a movable carrier 133 mounted in the housing 131 and movable along the optical axis of the lens assembly 140 relative to the housing 131. The lens assembly 140 is mounted on the movable carrier 133, and the housing 131 is mounted on the base 110.

Specifically, a coil and a magnet are generally further integrated on the housing 131. After the coil is energized, an electromagnetic force will be generated between the coil and the magnet. The electromagnetic force can drive the movable carrier 133 to move, thereby realizing the automatic zooming of the camera module 100.

Further, in this embodiment, the lens carrier 130 further includes pins 135 extending from one end of the housing 131 adjacent to the base 110 toward a side where the base 110 is located. The pins 135 are soldered to pads on the second board body 123.

Specifically, the pins 135 can be soldered to the second board body 123 by solder paste, so as to electrically connect the voice coil motor to the circuit board 120. Therefore, the voice coil motor can receive the current signal sent by the circuit board 120 to realize the automatic zooming. Moreover, the pins 135 can also fix the second board body 123 to the base 110, so that there is no need to additionally provide a fixing structure between the second board body 123 and the base 110.

In another embodiment, the pins 135 are bonded to the pads on the second board body 123 by conductive adhesive. The conductive adhesive can further realize the electrical connection between the voice coil motor and the circuit board 120, and fix the second board body 123. Moreover, there is no need to solder the circuit board 120 during assembly, and the operation is more convenient.

Referring to FIG. 2 again, in this embodiment, the camera module 100 further includes a suspension wire 180 having one end connected to the lens carrier 130 and the other end connected to the first board body 121 of the circuit board. The suspension wire 180 can be elastically stretched along its extending direction.

Specifically, a plurality of suspension wires 180 are generally provided, and one end of the suspension wire 180 is generally connected to an edge of the first board body 121. For the rectangular first board body 121, the four suspension wires 180 are respectively connected to four top corners of the first board body 121. The suspension wire 180 can be a common elastic cord, and thus can be elastically stretched and deformed. In the initial state, the suspension wire 180 may be in a natural state or a stretched state.

When the first board body 121 deviates from the initial position, the suspension wire 180 will be elastically stretched, so that a certain pulling force can be provided to the first board body 121. Therefore, when the anti-shake response does not occur, the suspension wire 180 can prevent the random movement of the first board body 121. When the anti-shake response occurs, the suspension wire 180 can also play a pulling effect on the first board body 121.

In the above camera module 100, the first board body 121 of the circuit board 120 can slide relative to the base 110 under the driving force, thereby driving the photosensitive chip 127 to displace relative to the lens assembly 140, so as to compensate for the offset of the optical axis of the lens assembly 140 caused by shaking, thereby achieving optical image stabilization. Since the photosensitive chip 127 is integrated on the first board body 121 of the circuit board 120 and moves therewith, there is no relative movement between the photosensitive chip 127 and the first board body 121. Moreover, the output pins of the second board body 123 of the circuit board 120 can be electrically connected to the mainboard of the mobile terminal, and the second board body 123 is fixed to the base 110. When the first board body 121 moves, the position of the second board body 123 can be kept fixed, so that there is no pulling between the second board body 123 and the mainboard. Therefore, the loosening of each connection due to the pulling force is effectively avoided. Moreover, the second board body 123 does not limit the movement of the first board body 121. Therefore, the resistance encountered by the first board body 121 of the circuit board 120 during the sliding process is also smaller. It can be seen that the above-mentioned camera module 100 has high reliability while realizing optical image stabilization.

The technical features of the above-described embodiments can be combined arbitrarily. To simplify the description, not all possible combinations of the technical features in the above embodiments are described. However, all of the combinations of these technical features should be considered as being fallen within the scope of the present application, as long as such combinations do not contradict with each other.

The foregoing embodiments merely illustrate some embodiments of the present application, and descriptions thereof are relatively specific and detailed. However, it should not be understood as a limitation to the patent scope of the present application. It should be noted that, a person of ordinary skill in the art may further make some variations and improvements without departing from the concept of the present application, and the variations and improvements falls in the protection scope of the present application. Therefore, the protection scope of the present application shall be subject to the appended claims.

## Claims

1. A circuit board, applied in a camera module, **characterized by**, comprising
a first board body provided with a photosensitive chip on a surface thereof;
a second board body provided with output pins; and
a connecting member connected between the second board body and the first board body, wherein as the first board body approaches or moves away from the second board body relatively, at least a part of the connecting member is deformed.

2. The circuit board according to claim 1, wherein the connecting member is a flexible connecting member; as the first board body approaches or moves away from the second board body relatively, a bending degree of the flexible connecting member changes.

3. The circuit board according to claim 2, wherein the flexible connecting member is a plurality of flexible cables arranged side by side and at intervals; one end of each of the flexible cables is electrically connected to the first board body, and the other end of each of the flexible cables is electrically connected to the second board body; or
the flexible connecting member is a flexible plate electrically connecting the first board body and the second board body.

4. The circuit board according to claim 1, wherein the connecting member is an elastic retractable member that is extensible; as the first board body approaches or moves away from the second board body relatively, the elastic retractable member is elastically deformed to change its length.

5. A camera module, **characterized by**, comprising:
a base;
a lens carrier equipped with a lens assembly, mounted on the base; and
the circuit board according to any one of claims 1 to 4,
wherein a side of the first board body facing away from the photosensitive chip is slidably mounted on the base; the second board body is fixed on the base; the first board body is disposed between the lens assembly and the base, and the first board body is disposed perpendicular to an optical axis of the lens assembly.

6. The camera module according to claim 5, wherein the lens carrier comprises a housing and a movable carrier mounted in the housing and movable along the optical axis of the lens assembly relative to the housing; the lens assembly is mounted on the movable carrier, and the housing is mounted on the base.

7. The camera module according to claim 6, wherein the lens carrier further comprises pins extending from the housing, and the pins are soldered to pads on the second board body.

8. The camera module according to claim 6, wherein the lens carrier further comprises pins extending from the housing, and the pins are bonded to pads on the second board body by conductive adhesive.

9. The camera module according to claim 5, further comprising a plurality of balls provided on the base, wherein the side of the first board body facing away from the photosensitive chip rests on a side of the plurality of balls facing away from the base.

10. A mobile terminal, **characterized by**, comprising the camera module according to any one of claims 5 to 9.
